# EUROPÄISCHE PATENTANMELDUNG

(11) **EP 1 193 747 A2**
(43) Veröffentlichungstag der Anmeldung: **03.04.2002**
(21) Anmeldenummer: 01121311.3
(22) Anmeldetag: 06.09.2001
(51) Int. Cl.: H01L 21/3065, H01L 21/311, H01L 21/3213

(54) **Verfahren zum Strukturieren eines Substrats**

(30) Priorität: 15.09.2000 DE 10045793
(71) Anmelder: CARL ZEISS, 89519 Heidenheim (DE)
(72) Erfinder: Hamm, Uwe W. Dr., 89129 Langenau (DE); Kasparek, Markus, 77704 Oberkirch/Baden (DE); Jacobs, Oliver, 89551 Ochsenberg (DE)
(74) Vertreter: Fuchs Mehler Weiss & Fritzsche

(57) **Zusammenfassung**

Es wird ein Verfahren zum Strukturieren eines Substrats mit Strukturen im Mikrometer bis Nanometerbereich beschrieben, das auf die Bereitstellung von gasförmigen fluororganischen Verbindungen verzichtet. Das Verfahren erfolgt durch reaktives Ionenätzen unter Verwendung einer auf dem Substrat angeordneten Maske und eines Plasmas sowie von fluorhaltigen organischen Verbindungen, wobei die fluorhaltige(n) organische(n) Verbindung(en) als feste Polymere bereitgestellt werden. Es wird auch ein Verfahren zum Ätzen einer Beschichtung auf einem Substrat oder der Oberfläche eines Substrates beschrieben.

## Beschreibung

Die Erfindung betrifft ein Verfahren zum Strukturieren eines Substrats im Mikrometer- bis Nanometerbereich, insbesondere von Silizium oder Silizium-Sauerstoff-Verbindungen, speziell Siliziumdioxid, durch reaktives Ionenätzen unter Verwendung von fluorhaltigen organischen Verbindungen. Außerdem betrifft die Erfindung ein Verfahren zum Ätzen einer Beschichtung auf einem Substrat oder der Oberfläche eines Substrats, insbesondere zum Ätzen von Silizium, Siliziumdioxid oder Molybdän, durch reaktives Ionenätzen unter Verwendung von fluorhaltigen organischen Verbindungen.

In der Halbleiterindustrie werden Strukturierungen von insbesondere Silizium oder auch Quarz durch sogenanntes reaktives Ionenätzen vorgenornmen. Man geht dabei so vor, daß zunächst das zu ätzende Substrat mit einem Photoresist beschichtet wird. Auf diese Photoresistschicht wird die geplante Strukturierung abgebildet. Der Photoresist wird entwickelt, so daß sich frei zugängliche Substratbereiche ergeben. Diese frei zugänglichen Bereiche des Substrats werden mit gasförmigen fluororganischen Verbindungen, wie z.B. Tetrafluormethan in einem Plasmaprozeß angeätzt. Bei dem Ätzen von Silizium oder Siliziumdioxid entsteht dann beispielsweise flüchtiges Siliziumtetrafluorid.

Desweiteren lassen sich durch reaktives Ionenätzen auch großflächige Schichten abtragen. Dies ist z.B. bei der Herstellung von Röntgen- oder UV-Spiegeln auf der Basis von Viellagensystemen aus beispielsweise Si/Mo auf Substraten aus z.B. Silizium oder Siliziumoxid von Bedeutung. Während des Herstellungsprozesses oder zur Wiedergewinnung von bereits verwendeten Substraten kann es vonnöten sein, bereits vorhandene Lagen teilweise oder ganz wegzuätzen.

Die WO 99/49506 lehrt, daß sowohl Silizium als auch Siliziumdioxid mit Hilfe von fluorhaltigen Plasmen geätzt werden können. Um unterschiedliche Ätzvorgänge z.B. bei komplexeren Strukturen besser kontrollieren zu können, können mit Hilfe von fluorierten Kohlenstoffen Seitenwandpassivierungen aufgebaut werden, indem beispielsweise Polytetrafluorethylen (PTFE) gebildet wird. Diese Seitenwandpassivierung kann ihrerseits später mit Hilfe eines Sauerstoffplasmas oder mit Hilfe eines Plasmas auf der Basis von Sauerstoff gemischt mit Argon, Helium oder Stickstoff wieder entfernt werden.

Der US 5,281,302 entnimmt man, daß Siliziumoxid oder Siliziumnitride sowie organische Kontaminanten mittels einer Mischung aus fluorierten Kohlenstoffen, Ozon und Sauerstoffplasma geätzt werden können. Bei den organischen Kontaminanten kann es sich insbesondere um fluorierte Kohlenwasserstoffe handeln. Diese werden in Kohlendioxid, Wasser und flüchtige Reste umgesetzt. Das Siliziumdioxid wird in Siliziumtetrafluorid und Kohlendioxid umgesetzt.

Die US 5,685,916 betrifft ein Verfahren zum Trockenreinigen mittels Plasmaätzen von Reaktionskammern für die Halbleiterelementherstellung. Dabei reagieren die Kontaminanten in der Reaktionskammer unter Einfluß eines in das Plasma eingebrachten, nichtflüssigen "Verstärkungs"-Material zu flüchtigen Verbindungen, die über das Vakuumsystem evakuiert werden können. Als derartiges "Verstärkungs"-Material wird insbesondere Photoresist vorgeschlagen.

Die EP 0 296 419 A2 offenbart ein Verfahren zum Ätzen eines Gegenstandes. Eine Gasmischung aus einem ätzenden Gas wie CF₃B, aus Xenon oder Krypton und gegebenenfalls Sauerstoff bereitgestellt wird. In dieser Mischung wird ein Plasma gezündet und damit der Gegenstand geätzt. Zusätzlich ist vorgesehen, einen weiteren Feststoff, vorzugsweise Graphit, in das Plasma einzubringen. Das Graphit reagiert im Plasma mit der Gasmischung, was dazu führt, daß einerseits das Ätzen des Gegenstandes kontrolliert abläuft, andererseits die Ätzkammer weniger mit organischen Verbindungen kontaminiert wird.

Aus der EP 0 802 560 A1 entnimmt man, daß Siliziumoxid mit Hilfe von fluorierten Kohlenwasserstoffen oder fluorierten Kohlenstoffen plasmageätzt werden kann. Dazu werden beispielsweise CF₄, C₂F₆, C₃F₈ und CHF₃ eingesetzt. Durch das Plasma bilden sich unterschiedliche Fragmente, insbesondere F-, CF- und CF₂-Radikale. Das Fluorradikal ätzt das Siliziumoxid. Die anderen Radikale aber bilden C-F-Polymere, die sich in der Reaktionskammer ablagern können. Diese allerdings werden wiederum von dem bei der Zersetzung des Siliziumoxids gebildeten Sauerstoff und den freien Fluorradikalen geätzt.

Die herkömmlichen Verfahren weisen den Nachteil auf, daß die fluorhaltigen organischen Verbindungen in Gasform zugeführt werden. Dies bringt einen erhöhten logistischen Aufwand mit sich, um diese Gase zur Verfügung zu stellen. An den Reaktionskammern benötigt man zusätzliche Öffnungen, um die gasförmigen fluororganischen Verbindungen in die Reaktionskammer einbringen und entfernen zu können. An diesen Stellen können die Reaktionskammern undicht werden, was zu Kontamination der Reaktionskammer führen kann. Außerdem sind die flüchtigen fluororganischen Verbindungen teilweise giftig, brennbar und explosiv.

Es ist daher Aufgabe der vorliegenden Erfindung, ein Ionenätzverfahren zur Verfügung zu stellen, daß auf die Bereitstellung von gasförmigen fluororganischen Verbindungen verzichtet.

Gelöst wird diese Aufgabe durch ein Verfahren zum Strukturieren eines Substrats mit Strukturen im Mikro- bis Nanometerbereich, insbesondere von Substraten aus Silizium oder Silizium-Sauerstoff-Verbindungen, speziell Siliziumdioxid, durch reaktives Ionenätzen unter Verwendung einer auf dem Substrat angeordneten Maske und eines Plasmas sowie von fluorhaltigen organischen Verbindungen, das sich dadurch auszeichnet, daß die fluorhaltige(n) organische(n) Verbindung(en) als feste Polymere bereitgestellt werden.

Außerdem wird diese Aufgabe durch ein Verfahren zum Ätzen einer Beschichtung auf einem Substrat oder der Oberfläche eines Substrats, insbesondere zum Ätzen von Silizium, Siliziumdioxid oder Molybdän, durch reaktives Ionenätzen unter Verwendung eines Plasmas sowie von fluorhaltigen organischen Verbindungen, das sich dadurch auszeichnet, daß die fluorhaltige(n) organische(n) Verbindung(en) als feste Polymere bereitgestellt werden.

Es hat sich herausgestellt, daß das sich in der Reaktionskammer befindliche fluorhaltige Polymer durch das beim reaktiven Ionenätzen angelegte Plasma zersetzt wird, so daß Fluorradikale, elementares Fluor und je nach Polymer auch Fluorwasserstoff freigesetzt werden. Diese tragen einerseits das an der Oberfläche des Substrats befindliche Material ab. Andererseits reagieren sie mit diesem Material zu flüchtigen Reaktionsprodukten, beispielsweise SiF₄, wenn Silizium oder Siliziumdioxid vorhanden sind.

Durch das erfindungsgemäße Verfahren wird ermöglicht, die für das reaktive Ionenätzen notwendigen Reagenzien zur Verfügung zu stellen, ohne mit wegen ihrer Giftigkeit oder Brennbarkeit bzw. Explosivität gefährlichen Gasen hantieren zu müssen. Auch das kontaminationsfreie Ablaufen des Strukturier-bzw. Ätzprozesses wird durch das erfindungsgemäße Verfahren gefördert. Denn im Gegensatz zu herkömmlichen Verfahren, bei denen Kontamination durch die Gaszuleitungen, Gasventile und eventuelle undichte Stellen an den Anschlüssen zur Reaktionskammer eingetragen werden können, ist die Kontaminationsgefahr beim erfindungsgemäßen Verfahren zeitlich auf das Einbringen des fluorhaltigen Polymers vor Beginn des Verfahrens beschränkt. Anders als bei den herkömmlichen Verfahren, bei denen man nur schwer das lokale Reaktionsverhalten über gezieltes örtliches Einströmenlassen der Reaktionsgase mit Hilfe von teilweise komplizierten Düsensystemen und unter Berücksichtigung von Konvektion, kann im erfindungsgemäßen Verfahren durch gezieltes Anbringen des fluorhaltigen Polymers auf die örtliche Verteilung der Reaktion Einfluß genommen werden.

In einer bevorzugten Ausführungsform des erfindungsgemäßen Verfahrens wird die fluorhaltige organische Verbindung dem Prozeß in Form von Folie zugeführt. Folien sind insbesondere für weitflächige Anwendungen von Vorteil. Gegebenenfalls lassen sich in Folien auf einfache Art und Weise beipielsweise durch Stanzen oder Ausschneiden Strukturen einbringen, um lokal unterschiedliche Konzentrationen von fluororganischen Verbindungen hervorzurufen. Außerdem sind so gut wie alle fluorhaltigen Polymere im Handel auch als Folien zu erhalten.

Die besten Ergebnisse wurden erzielt, indem das fluorhaltige Polymer, insbesondere die Polymerfolie beabstandet zur Maske angeordnet wird und zwischen dem Polymer, insbesondere der Polymerfolie und der Maske bzw. dem Substrat das Plasma gezündet wird. Dadurch laufen die Zersetzung des Polymers sowie die Zersetzung des Substrates räumlich getrennt ab, so daß sie sich bei der Reaktion nicht negativ beeinflussen können.

Es hat sich von Vorteil erwiesen, als Plasma ein Sauerstoffplasma einzusetzen. Das Vorhandensein von Sauerstoffionen und Sauerstoffradikalen übt einen verstärkenden Einfluß auf die Bildung der reaktiven Spezies aus dem fluorhaltigen Polymer, wie beispielsweise Fluor- und Fluorwasserstoff aus.

Desweiteren führt das Sauerstoffplasma dazu, daß etwaige organische Reaktionsprodukte in Form von Kohlendioxid abgeführt werden können.

Die besten Ergebnissse wurden bei Drücken zwischen 0,5 bis 1,5 mbar erzielt. Zum Anregen des Plasmas werden vorzugsweise elektromagnetische Wellen aus dem Hochfrequenzbereich, dem Radiofrequenzbereich oder dem Mikrowellenbereich eingekoppelt. Bei den Mikrowellenfrequenzen werden insbesondere Frequenzen im Bereich der Elektronzyklotronresonanz bevorzugt.

Vorteilhafterweise sind die Polymer- und die Substratoberfläche parallel zueinander angeordnet. Die besten Ergebnisse wurden erreicht, wenn zwischen dem Polymer und dem zu strukturierenden Substrat ein Abstand zwischen 2 cm und 20 cm eingehalten wird.

Neben dem chemischen Ätzen erfolgt Materialabtrag auch durch physikalische Wechselwirkungen, beispielsweise Sputterprozesse. In einer bevorzugten Ausführungsform werden zur Erhöhung des Sputteranteils im Plasma Inertgase, wie beispielsweise Argon oder auch Helium oder Stickstoff beigemischt.

Vorzugsweise werden als fluorhaltige organische Verbindungen Polytetrafluorethylen, Perfluoralkoxy-Copolymere und/oder Polyvinylidenfluoride eingesetzt. Unter Umständen kann aber auch der Einsatz von Tetrafluorethylen/Hexafluorpropylen-Copolymer, Tetrafluorethylen/Ethylen-Copolymer, Tetrafluorethylen/Hexafluropropylen/Vinylidenfluorid-Terpolymer, Polytrifluorchlorethylen, Trifluorchlorethylen/Ethylen-Copolymer oder Polyvinylfluorid von Vorteil sein.

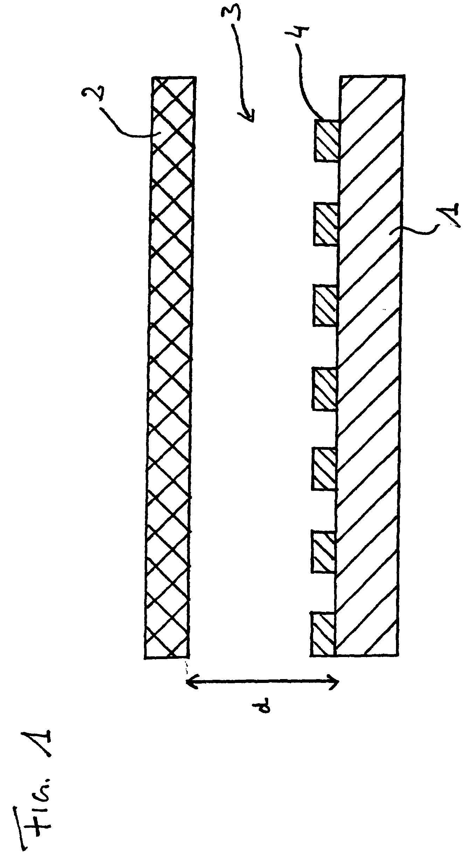

In Figur 1 ist schematisch eine beispielhafte Anordnung von einem Substrat 1, einer Maske 4 sowie einer Polytetrafluorethylen-Folie 2 relativ zueinander dargestellt. Diese einzelnen Komponenten befinden sich in einer nicht dargestellten Beschichtungskammer. Die Maske 4 aus Photoresist wurde mit Hilfe von lithographischen Methoden auf das Substrat 1 aufgebracht. Die Polytetrafluorethylen-Folie ist in einem Abstand d = 5 cm zum Substrat angeordnet. In dem Zwischenraum 3 zwischen der Polytetrafluorethylen-Folie und dem Substrat 1 wird das Plasma gezündet. Der Abstand d ist derart gewählt, daß die Ätzrate in der Substratebene möglichst homogen ist. Das Plasma zersetzt die Polytetrafluorethylen-Folie 2, so daß Fluorradikale frei werden, die ihrerseits die nicht von der Maske 4 abgedeckten Stellen des Substrates 1 zersetzen.

### Beispiel 1

Parallel zu einem Quarzsubstrat wurde in 6 cm Abstand eine Polytetrafluorethylen-Folie im Plasmareaktor angeordnet. Bei einem Sauerstoffluß von 160 ml pro Minute wurde ein Sauerstoffpartialdruck von 0,5 mbar im Plasmareaktor eingestellt. In dem Plasmareaktor wurden Elektronzyklotronresonanz-Mikrowellen einer Frequenz von 2,45 GHz mit einer Leistung von 800 W eingekoppelt. Das Quarzsubstrat wurde über 10 Minuten dem Sauerstoffplasma ausgesetzt. Es wurde eine Ätzrate von ca. 2 nm pro Minute erreicht.

### Beispiel 2

In einem Abstand von 5 cm wurde parallel zu einem Molybdän/Silizium-Viellagensystem eine Polyvinylidenfluorid-Folie im Plasmareaktor angeordnet. Bei einem Sauerstofffluß von 250 ml pro Minute wurde ein Sauestoffpartialdruck von 1,4 mbar eingestellt. Es wurden Radiofrequenzen von 3 MHz in das Sauerstoffplasma eingekoppelt. Die Plasmaleistung betrug 600 W. Das Silizium bildete mit dem Fluor flüchtiges Siliziumtetrafluorid. Bei der Ätzung des Molybdäns bildeten sich flüchtige Molybdänoxyfluoride. Das Viellagensystem aus Molybdän und Silizium wurde 30 Minuten der Sauerstoffplasmabehandlung ausgesetzt. Danach waren alle Silizium- und Molybdänlagen bis auf das Substrat abgetragen.

### Beispiel 3

Ein Siliziumwafer sollte strukturiert werden. Dazu wurde in dem Plasmareaktor eine Folie aus Perfluoralkoxy-Copolymer eingebracht. Über einen Sauerstofffluß von 210 ml pro Minute wurde ein Sauerstoffpartialdruck von 0,9 mbar eingestellt. Eingekoppelt wurden hochfrequente magnetische Wellen einer Frequenz von 13,56 MHz. Die Plasmaleistung betrug 700 W. Außerdem wurde dem Plasma Argon beigemischt, um die Sputterwirkung zu erhöhen. Nach einer Behandlungsdauer von 2 Minuten war eine hinreichende Strukturierung erfolgt.

## Patentansprüche

1. Verfahren zum Strukturieren eines Substrats mit Strukturen im Mikrometer- bis Nanometerbereich, insbesondere von Substraten aus Silizium oder Silizium-Sauerstoff-Verbindungen, speziell Siliziumdioxid, durch reaktives Ionenätzen unter Verwendung einer auf dem Substrat angeordneten Maske und eines Plasmas sowie von fluorhaltigen organischen Verbindungen, **dadurch gekennzeichnet, daß** die fluorhaltige(n) organische(n) Verbindung(en) als feste Polymere bereitgestellt werden.

2. Verfahren zum Ätzen einer Beschichtung auf einem Substrat oder der Oberfläche eines Substrats, insbesondere zum Ätzen von Silizium, Siliziumdioxid oder Molybdän, durch reaktives Ionenätzen unter Verwendung eines Plasmas sowie von fluorhaltige(n) organische(n) Verbindung(en), **dadurch gekennzeichnet, daß** die fluorhaltige(n) organische(n) Verbindung(en) als feste Polymere bereitgestellt werden.

3. Verfahren nach Anspruch 1 oder 2, **dadurch gekennzeichnet, daß** das fluorhaltige Polymer als Folie verwendet wird.

4. Verfahren nach einem der Ansprüche 1-3, **dadurch gekennzeichnet, daß** das fluorhaltige Polymer, insbesondere die Polymerfolie, beabstandet zur Maske angeordnet wird und daß in dem Raum zwischen dem Polymer, insbesondere der Polymerfolie und der Maske bzw. dem Substrat das Plasma gezündet wird.

5. Verfahren nach einem der Ansprüche 1 bis 4, **dadurch gekennzeichnet, daß** ein Sauerstoffplasma eingesetzt wird.

6. Verfahren nach einem der Ansprüche 1 bis 5, **dadurch gekennzeichnet, daß** Drücke zwischen 0,5 bis 1,5 mbar eingestellt werden.

7. Verfahren nach einem der Ansprüche 1 bis 6, **dadurch gekennzeichnet, daß** ein Hochfrequenz-, ein Radiofrequenz- oder ein Mikrowellenplasma eingesetzt wird.

8. Verfahren nach einem der Ansprüche 1 bis 7, **dadurch gekennzeichnet, daß** die Polymer- und die Substratoberfläche parallel zueinander angeordnet werden.

9. Verfahren nach einem der Ansprüche 1 bis 8, **dadurch gekennzeichnet, daß** der Abstand zwischen Polymer und Substrat zwischen 2 cm und 20 cm gewählt wird.

10. Verfahren nach einem der Ansprüche 1 bis 9, **dadurch gekennzeichnet, daß** dem Plasma ein oder mehrere Inertgase beigemischt werden.
